# FASCICULE DE BREVET EUROPEEN

(11) **EP 3 082 266 B1**
(45) Date de publication et mention de la délivrance du brevet: **16.08.2017**
(21) Numéro de dépôt: 16164904.1
(22) Date de dépôt: 12.04.2016
(51) Int. Cl.: H03M 13/11, H03M 13/29, H03M 13/35, H03M 13/15, H03M 13/27

(54) **PROCEDES DE CODAGE ET DECODAGE A PROTECTION DIFFERENCIEE**
KODIER- UND DEKODIERVERFAHREN ZUM DIFFERENZIERTEN SCHUTZ
ENCODING AND DECODING METHODS WITH DIFFERENTIATED PROTECTION

(30) Priorité: 17.04.2015 FR 1500806
(43) Date de publication de la demande: 19.10.2016
(73) Titulaire: THALES, 92400 Courbevoie (FR)
(72) Inventeur: RAIMONDI, Mathieu, 31100 TOULOUSE (FR); GADAT, Benjamin, 31100 TOULOUSE (FR); AL BITAR, Hanaa, 31100 TOULOUSE (FR)
(74) Mandataire: HAMMES, Pierre

(56) Documents cités:
- US-A1- 2013 145 231
- SANDBERG S ET AL: "Design of bandwidth-efficient unequal error protection LDPC codes", IEEE TRANSACTIONS ON COMMUNICATIONS, IEEE SERVICE CENTER, PISCATAWAY, NJ. USA, vol. 58, no. 3, mars 2010 (2010-03), pages 802-811, XP011304246, ISSN: 0090-6778, DOI: 10.1109/TCOMM.2010.03.0800352
- YANG HAN ET AL: "Low-floor decoders for LDPC codes", IEEE TRANSACTIONS ON COMMUNICATIONS, IEEE SERVICE CENTER, PISCATAWAY, NJ. USA, vol. 57, no. 6, juin 2009 (2009-06), pages 1663-1673, XP011262820, ISSN: 0090-6778, DOI: 10.1109/TCOMM.2009.06.070325
- SHIEH SHIN-LIN: "Concatenated BCH and LDPC Coding Scheme With Iterative Decoding Algorithm for Flash Memory", IEEE COMMUNICATIONS LETTERS, IEEE SERVICE CENTER, PISCATAWAY, NJ, US, vol. 19, no. 3, mars 2015 (2015-03), pages 327-330, XP011574612, ISSN: 1089-7798, DOI: 10.1109/LCOMM.2015.2391260 [extrait le 2015-03-06]
- NARAYANAN K R ET AL: "Selective serial concatenation of turbo codes", IEEE COMMUNICATIONS LETTERS, IEEE SERVICE CENTER, PISCATAWAY, NJ, US, vol. 1, no. 5, septembre 1997 (1997-09), pages 136-139, XP011423310, ISSN: 1089-7798, DOI: 10.1109/4234.625037
- MAHDAVIFAR HESSAM ET AL: "Performance Limits and Practical Decoding of Interleaved Reed-Solomon Polar Concatenated Codes", IEEE TRANSACTIONS ON COMMUNICATIONS, IEEE SERVICE CENTER, PISCATAWAY, NJ. USA, vol. 62, no. 5, mai 2014 (2014-05), pages 1406-1417, XP011548388, ISSN: 0090-6778, DOI: 10.1109/TCOMM.2014.050714.130602 [extrait le 2014-05-15]

## Description

La présente invention concerne le domaine des télécommunications numériques et plus précisément le domaine du codage de canal qui vise l'utilisation de codes correcteurs dans le but d'augmenter le niveau de redondance de l'information transmise de sorte à pouvoir reconstruire le message initialement généré malgré les erreurs introduites lors de la transmission de ce message à travers un canal de propagation non parfait.

L'invention concerne plus particulièrement le domaine des codes correcteurs du type codes LDPC (Low Density Parity Codes) ou tout autre type de code correcteur pouvant être représenté sous la forme d'un graphe bipartite appelé graphe de Tanner.

L'invention porte sur un procédé de codage et un procédé de décodage permettant d'appliquer une protection différenciée aux données à transmettre en fonction de niveaux de priorité différents.

L'invention s'applique avantageusement aux standards de radionavigation par satellite ou standards GNSS (Global Navigation Satellite System) tels que les standards GPS ou Galileo.

Les standards GNSS définissent des messages GNSS qui sont transmis via des trames de données. De tels messages comprennent des données relatives à des informations de positionnement tels que des éphémérides satellites, des informations sur l'horloge du satellite, des données de service ou encore d'intégrité. Dans les standards actuels, ces données sont protégées par un code correcteur simple qui est appliqué directement sur l'ensemble d'une trame de données. Cette méthode présente l'inconvénient de ne pas permettre une optimisation fine du compromis entre le débit consommé par l'ajout du code correcteur et le niveau de protection nécessaire.

En effet, les données transmises dans une trame GNSS sont de natures diverses et peuvent être classifiées en plusieurs groupes présentant des niveaux de priorité différents. Par niveau de priorité, on entend ici, un niveau de priorité sur la criticité des données à transmettre. Certaines données sont plus importantes que d'autres et nécessitent donc un niveau de protection par codage correcteur plus important pour assurer leur transmission correcte avec un niveau de fiabilité compatible du niveau de priorité.

L'invention peut s'appliquer de façon similaire à d'autres systèmes de transmission de données pour lesquels il est possible de regrouper les données en plusieurs ensembles ayant des niveaux de priorité différents.

On connait par ailleurs les documents « Design of bandwidth-efficient unequal error protection LDPC codes », Sandberg S, von Deetzen N, IEEE Transactions on communications et « Low-floor decoders for LDPC codes », Yang Han, W Ryan, IEEE transactions on communications qui décrivent des méthodes de codage à protection différenciée.

L'invention propose un procédé de codage à protection différenciée qui permet de protéger avec un rendement de protection différent, plusieurs groupes de données dans une trame à émettre.

L'invention est basée pour cela sur l'emploi d'un code correcteur du type LDPC concaténé avec un code correcteur algébrique.

L'invention propose également un procédé de décodage compatible du procédé de codage à protection différenciée.

Les procédés selon l'invention sont avantageusement applicables à des systèmes de transmission de données pour lesquels les données sont formatées en trames de courtes durées, typiquement de l'ordre de quelques centaines de bits. En particulier, l'invention s'applique à la protection de données transmises dans un système GNSS.

L'invention a pour objet un procédé de codage à protection différenciée appliqué à une trame comprenant un ensemble de bits, le codage étant effectué au moins à partir d'un premier code correcteur systématique du type code LDPC, représenté par un graphe bipartite, dit graphe de Tanner, comprenant une pluralité de premiers noeuds, appelés noeuds variables, ledit graphe comprenant en outre une pluralité de seconds noeuds, appelés noeuds de contrôle, chaque noeud variable étant connecté à au moins un noeud de contrôle par une branche, le nombre de branches reliées à un noeud variable étant appelé degré du noeud variable, dans lequel chaque noeud variable est associé à un bit d'un mot dudit premier code, les noeuds variables associés aux bits systématiques du mot du premier code étant appelés noeuds variables systématiques, ledit procédé comprenant les étapes suivantes :
- Décomposer la trame en une pluralité de sous-trames ayant chacune un niveau de priorité différent,
- Appliquer à chaque sous-trame obtenue, sauf à la sous-trame de niveau de priorité le plus faible, un second code correcteur algébrique de rendement prédéterminé, ledit rendement étant croissant avec la décroissance du niveau de priorité de chaque sous-trame lorsque le nombre de sous-trame est au moins égal à trois,
- Appliquer un entrelacement des bits de toutes les sous-trames de sorte à effectuer une mise en correspondance entre les noeuds variables systématiques dudit premier code correcteur systématique, rangés selon la valeur de leur degré, et les bits de chaque sous-trame, les sous-trames étant rangées selon leur niveau de priorité,
- Coder, à l'aide du premier code correcteur systématique, la trame composée des bits entrelacés de toutes les sous-trames concaténées.

Selon un aspect particulier du procédé de codage selon l'invention, les bits de chaque sous-trame sont mis en correspondance avec les noeuds variables systématiques dudit premier code correcteur systématique, rangés dans l'ordre croissant de la valeur de leur degré selon un ordre décroissant des niveaux de priorité des sous-trames.

Selon un aspect particulier du procédé de codage selon l'invention, les bits de chaque sous-trame sont mis en correspondance avec les noeuds variables systématiques dudit premier code correcteur systématique, rangés dans l'ordre croissant de la valeur de leur degré selon un ordre croissant des niveaux de priorité des sous-trames.

Selon un aspect particulier du procédé de codage selon l'invention, le premier code correcteur systématique est construit de sorte que la proportion de noeuds variables systématiques de degré égal au degré maximum est égale au ratio entre le nombre de bits de la sous-trame de niveau de priorité le plus élevé et le nombre de bits d'un mot dudit premier code correcteur systématique.

Selon un aspect particulier du procédé de codage selon l'invention, la décomposition de la trame en sous-trames est effectuée en réordonnant les bits de la trame selon leur niveau de priorité.

Selon un aspect particulier du procédé de codage selon l'invention, le niveau de priorité d'un bit est défini en fonction de la criticité de l'information associée au bit, du poids du bit ou de la fréquence de rafraichissement de l'information associée au bit.

Selon un aspect particulier du procédé de codage selon l'invention, les données transmises dans la trame sont des données d'un message de navigation par satellite généré par un système de radionavigation par satellite.

Selon un aspect particulier du procédé de codage selon l'invention, le second code correcteur algébrique est un code BCH.

L'invention a encore pour objet un procédé de décodage à protection différenciée appliqué à une trame codée comprenant un ensemble de bits codés à l'aide du procédé de codage à protection différenciée selon l'invention, le procédé de décodage comprenant les étapes suivantes :
- Effectuer un premier décodage de la trame codée à l'aide d'un premier algorithme de décodage d'un premier code correcteur systématique, du type code LDPC, basé sur l'exploitation d'un graphe bipartite, de sorte à obtenir une première trame décodée,
- Décomposer la première trame décodée en sous-trames, chaque sous-trame contenant les bits correspondant aux noeuds variables systématiques rangés selon la valeur de leur degré, les sous-trames étant rangées selon leur niveau de priorité,
- Effectuer un second décodage de chaque sous-trame obtenue, sauf de la trame de niveau de priorité le plus faible, à l'aide d'un second algorithme de décodage d'un second code correcteur algébrique de rendement prédéterminé, ledit rendement étant croissant avec la décroissance du niveau de priorité de chaque sous-trame lorsque le nombre de sous-trames est au moins égal à trois.

Le procédé de décodage à protection différenciée selon l'invention peut comprendre en outre une étape de concaténation des sous-trames en une seconde trame décodée.

Selon un aspect particulier du procédé de décodage selon l'invention, le second code correcteur est un code correcteur et détecteur d'erreurs, ledit procédé de décodage comprenant en outre les étapes suivantes :
- Lors du second décodage de chaque sous-trame, détecter si la sous-trame est correctement décodée ou non,
- Si la sous-trame est correctement décodée,
   i. Coder, avec ledit second code correcteur algébrique, chaque sous-trame décodée pour obtenir une sous-trame codée,
   ii. Appliquer une seconde itération du premier décodage en spécifiant à l'algorithme de décodage dudit premier code correcteur systématique, une vraisemblance maximale pour les bits de chaque sous-trame codée.

Selon un aspect particulier du procédé de codage selon l'invention, le second code correcteur algébrique est un code BCH.

Selon un aspect particulier du procédé de codage selon l'invention, le décodage du premier code correcteur systématique et le décodage du second code correcteur algébrique, sont réalisés conjointement.

L'invention a encore pour objet un dispositif de codage configuré pour exécuter les étapes du procédé de codage à protection différenciée selon l'invention, un dispositif de décodage configuré pour exécuter les étapes du procédé de décodage à protection différenciée selon l'invention, un émetteur de signaux de radio-navigation par satellite comprenant un dispositif de codage selon l'invention pour coder de façon différenciée des messages de radio-navigation par satellite et un récepteur de signaux de radio-navigation par satellite comprenant un dispositif de décodage selon l'invention pour décoder de façon différenciée des messages de radio-navigation par satellite.

D'autres caractéristiques et avantages de la présente invention apparaîtront mieux à la lecture de la description qui suit en relation aux dessins annexés qui représentent :
- La figure 1, un organigramme décrivant le procédé de codage à protection différenciée selon l'invention,
- La figure 2, un organigramme décrivant le procédé de décodage à protection différenciée selon l'invention selon un premier mode de réalisation,
- La figure 3, un organigramme décrivant le procédé de décodage à protection différenciée selon l'invention selon un second mode de réalisation,
- La figure 4, un diagramme illustrant les performances de l'invention en taux d'erreurs bits et taux d'erreurs trames en fonction du rapport signal sur bruit,
- La figure 5, un synoptique décrivant les éléments constitutifs d'un codeur à protection différenciée selon l'invention,
- La figure 6, un synoptique décrivant les éléments constitutifs d'un décodeur à protection différenciée selon l'invention,
- La figure 7, un synoptique d'un émetteur comprenant un codeur à protection différenciée selon l'invention,
- La figure 8, un synoptique d'un récepteur comprenant un codeur à protection différenciée selon l'invention.

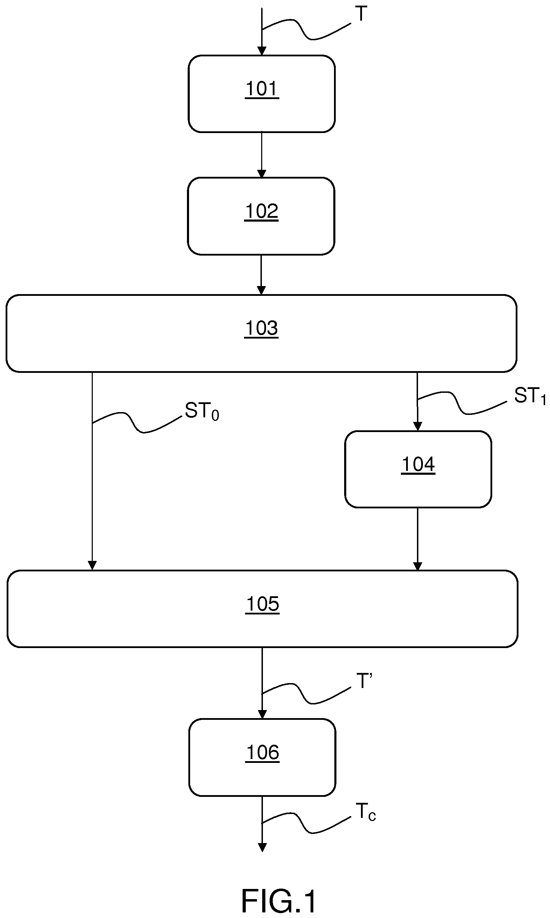

La figure 1 représente un synoptique qui décrit l'enchainement des étapes de mise en oeuvre du procédé de codage à protection différenciée selon l'invention.

Le procédé reçoit en entrée une trame T comprenant un ensemble de bits et produit à sa sortie une trame codée T_{c} en vue de sa transmission sur un canal radio, par exemple un canal de transmission satellitaire.

Selon une première étape 101, on affecte un niveau de priorité aux données transmises dans la trame T.

Le niveau de priorité de chaque bit est choisi en fonction de l'importance de l'information contenue dans ce bit. Autrement dit, un niveau de priorité élevé est affecté aux bits qui doivent être reçus en priorité. Un niveau de priorité élevé signifie que les bits associés doivent être protégés par un code correcteur de rendement de protection plus faible afin d'augmenter le niveau de protection sur ces bits pour augmenter ainsi la probabilité qu'ils soient correctement reçus après transmission à travers un canal radio.

Inversement, un niveau de priorité faible peut être affecté aux bits qui ne nécessitent pas une probabilité de réception correcte élevée et qui peuvent être transmis sans l'ajout de protection par un code correcteur ou avec une protection à l'aide d'un code correcteur de rendement de protection élevé.

Dans le cadre de l'application de l'invention à une trame de données GNSS, le niveau de priorité peut être affecté aux bits de la trame en prenant en compte les contraintes suivantes. En premier lieu, le niveau de priorité peut être fixé en fonction du type d'informations à transmettre. En effet, toutes les informations à transmettre n'ont pas un niveau de criticité égal.

En deuxième lieu, on peut affecter un niveau de priorité plus élevé aux bits de poids forts des données quantifiées afin de différencier la protection à appliquer en fonction du niveau de quantification des données. A l'inverse, les bits de poids faibles peuvent être associés à un niveau de priorité faible car ils sont moins significatifs et ne nécessitent donc pas une haute probabilité de réception correcte.

Enfin, certaines informations sont répétées au cours du temps avec une fréquence de rafraichissement plus ou moins grande. Un niveau de priorité élevé peut être affecté aux informations qui ne sont jamais répétées ou qui sont répétées à une fréquence faible. A l'inverse, les informations répétées à une fréquence élevée peuvent se voir affecter un niveau de priorité faible.

Les exemples d'affectation de niveaux de priorité aux bits de la trame T données ci-dessus le sont à titre illustratif et non limitatif. L'Homme du métier cherchant à appliquer l'invention à un standard particulier, pourra définir d'autres politiques de gestion des niveaux de priorité en fonction des besoins requis. L'idée générale dans l'application de l'étape 101 est de définir un niveau de priorité élevé aux bits qui nécessitent une forte probabilité de réception correcte et de définir un niveau de priorité faible aux bits qui présentent moins de contraintes sur leur taux de réception correct.

Le niveau de priorité peut être une valeur entière variant sur une plage donnée, par exemple entre 0 et M entier strictement positif, 0 étant le niveau de priorité le plus faible et M le niveau de priorité le plus élevé.

Dans une deuxième étape 102, la trame T est décomposée en Nₜ sous-trames en regroupant dans chaque sous-trame, les bits de niveau de priorité équivalents. Par exemple, si Nₜ est égal à deux, l'étape 102 consiste à regrouper dans une première sous-trame, les bits de niveau de priorité les plus élevés et dans une seconde sous-trame, les bits de niveau de priorité les plus faibles. Si Nₜ est supérieur à deux, on range les bits en fonction de leur niveau de priorité croissant et on construit Nₜ sous-trames comprenant chacune les bits ayant un niveau de priorité identique ou proche. La décomposition 102 de la trame T en sous-trames peut se faire en fixant des longueurs identiques pour les sous-trames ou en regroupant dans une sous-trame les bits ayant un même niveau de priorité auquel cas les sous-trames peuvent avoir des longueurs différentes.

Dans une troisième étape 103, les sous-trames obtenues sont démultiplexées pour être traitées chacune par une première opération de codage canal distincte pour chaque sous-trame. L'exemple de la figure 1 est limité à la génération de deux sous-trames mais peut être aisément étendu à un nombre de sous-trames supérieur à deux.

La sous-trame ST₀ regroupant les bits de niveaux de priorité les plus faibles n'est soumise à aucune opération de codage canal dans un premier temps et est directement transmise vers une étape 106 de multiplexage.

La sous-trame ST₁ regroupant les bits de niveaux de priorité les plus élevés est transmise à une étape 104 de codage canal qui consiste à appliquer à la sous-trame ST₁ un code correcteur algébrique, par exemple un code correcteur BCH.

Si un nombre Nₜ, supérieur à deux, de sous-trames est généré, un code correcteur algébrique du type code BCH est appliqué aux Nₜ -1 sous-trames comprenant les bits de niveaux de priorité les plus élevés. Chaque code correcteur est appliqué avec un rendement de protection différent et croissant avec la décroissance du niveau de priorité moyen de chaque sous-trame. La sous-trame de niveau de priorité moyen le plus faible est transmise sans codage directement à l'étape de multiplexage 106.

A titre d'exemple, si on considère trois sous-trames, les rendements de codage utilisés peuvent être, par exemple, égaux à 0, 2/3 et 3/4 respectivement.

L'ensemble des sous-trames est ensuite multiplexé, dans une étape 105, pour reconstruire une trame de même taille que la trame T reçue en entrée de la première étape 101. Cette trame reconstruite est ensuite codée, dans une étape 106, par un second code correcteur. Le second code correcteur est un code correcteur du type code LDPC (Low Density Parity Code) ou tout code correcteur du même type qui peut être représenté à l'aide d'un graphe bipartite appelé graphe de Tanner.

L'ouvrage de référence [1], et en particulier le chapitre 5 intitulé « Low-density parity-check codes », décrivent en détail la construction et la représentation d'un code correcteur de type LDPC à l'aide d'un graphe bipartite dit de Tanner.

Un graphe de Tanner est composé de deux types de noeuds. Un premier type de noeud est appelé noeud variable ou, en anglais « variable node » ou encore « code-bit node » selon les usages. Les noeuds variables sont chacun associés à un bit d'un mot de code. Il y a donc autant de noeuds variables que de bits dans le mot de code à décoder. Chaque noeud variable est connecté à un ou plusieurs noeuds de contrôle, appelés « check nodes » ou « constraint nodes » en anglais. Le nombre de noeuds de contrôle est égal au nombre de lignes de la matrice de parité du code correcteur. Le nombre de noeud variables est égal au nombre de colonnes de la matrice de parité. Un noeud de contrôle d'indice i est connecté à un noeud variable d'indice j si et seulement si l'élément de la ligne i et de la colonne j de la matrice de parité du code est égal à 1. Une connexion entre un noeud variable et un noeud de contrôle est appelé une branche. Le nombre de connexions partant d'un noeud est le degré d'un noeud.

Le code correcteur utilisé dans l'étape 106 pour coder la trame multiplexée doit en outre être un code correcteur systématique. Ce type de code est par exemple décrit au chapitre 6.5.2 de l'ouvrage [1] qui porte sur les codes dits « Irregular Repeat-Accumulate Codes » encore appelés codes IRA. De tels codes ont la particularité d'être générés à partir d'une matrice de parité de la forme H=[H_{U} H_{P}]. H_{P} est une matrice carrée de taille m x m où m est le nombre de noeuds de contrôle du code. H_{U} est une matrice à m lignes et n-m colonnes, avec R=m/n le rendement du code. H_{P} est une matrice dite bi-diagonale dont la forme est donnée en page 269, relation (6.4) de l'ouvrage [1]. Comme indiqué ci-dessus, le nombre de noeud variables est égal au nombre de colonnes de la matrice de parité H. Dans le cas de codes systématiques IRA, on peut distinguer les noeuds variables associés aux colonnes de la matrice H_{U} et les noeuds variables associés aux colonnes de la matrice H_{P}. Ces derniers correspondent aux bits systématiques du mot de code et seront appelés par la suite noeuds variables systématiques. Les bits systématiques sont les bits utiles en entrée de l'opération de codage, par opposition aux bits de parité qui sont les bits de redondance ajoutés par l'opération de codage. Alternativement, la matrice de parité H peut également prendre la forme H=[H_{P} H_{U}], le choix de l'ordre entre les matrices H_{P} et H_{U} étant déterminé par convention.

On revient à présent à la description du procédé de codage selon l'invention. Dans une étape 105 supplémentaire, exécutée après l'étape 104 et avant l'étape 106, les sous-trames codées par application d'un code correcteur algébrique lors de l'étape 104 sont entrelacées à l'aide d'un entrelaceur qui a pour fonction de mettre en correspondance les bits des sous-trames codées avec les noeuds variables systématiques du graphe bipartite du code correcteur systématique LDPC. La mise en correspondance dépend d'une part du niveau de priorité moyen de la sous-trame et d'autre part du degré des noeuds variables systématiques.

L'introduction de l'étape 105 est basée sur le constat que les noeuds variables les plus connectés dans un graphe de Tanner, c'est-à-dire les noeuds de degré le plus élevé, sont ceux pour lesquels les bits du mot de code associés à ces noeuds ont la plus grande probabilité d'être faux après le décodage du mot de code.

L'invention tire profit de cette constatation pour mettre en correspondance les bits des sous-trames codées et les noeuds variables systématiques du graphe de Tanner du code LDPC de sorte à optimiser les performances globales de décodage de la trame codée T_{c} en sortie de l'opération de codage 106 par un code correcteur systématique du type LDPC.

L'étape 105 consiste ainsi dans un premier temps à ranger les noeuds variables systématiques du graphe de Tanner du code LDPC utilisé dans l'étape 106 selon un ordre, croissant ou décroissant, de leurs degrés. Cette étape peut être effectuée à partir de la matrice de parité H du code puisque les noeuds variables systématiques correspondent aux n-m premières (ou dernières) colonnes de la matrice H et le degré de chaque noeud variable est donné par la somme des valeurs de la colonne de la matrice H associée au noeud variable.

Dans un second temps, on met en correspondance les sous-trames codées et la sous-trame non codée avec les noeuds variables systématiques du code LDPC en fonction du niveau de priorité moyen de la sous-trame et des degrés des noeuds variables.

Pour ce faire, une première stratégie consiste à associer les sous-trames de niveaux de priorité les plus élevés avec les noeuds variables systématiques de degrés les plus faibles. Ainsi, on favorise une probabilité de décodage correcte plus élevée pour les sous-trames les plus prioritaires.

Dans l'exemple de la figure 1, les bits de la sous-trame ST₁ codés 104 par le code correcteur algébrique BCH, sont mis en correspondance avec les noeuds variables systématiques de degrés les plus faibles. Les bits de la sous-trame ST₀ non codés sont mis en correspondance avec les noeuds variables systématiques de degrés les plus élevés. La mise en correspondance peut être réalisée par une opération d'entrelacement qui consiste à ranger les bits de chaque sous-trame dans une trame T' produite en entrée de l'étape de codage 106. Les indices des bits de la trame T' correspondent aux indices des noeuds variables systématiques de la matrice de parité du code correcteur de type LDPC. L'opération d'entrelacement ou mise en correspondance peut être faite à l'aide d'un vecteur de même taille que la trame T' qui contient les indices des noeuds variables systématiques rangés dans l'ordre croissant ou décroissant des valeurs de leurs degrés. Toute autre implémentation équivalente de l'étape 105 est envisageable.

Pour mieux expliciter l'opération effectuée par l'étape 105, on décrit un exemple numérique qui n'est pas forcément représentatif d'une situation réelle mais qui permet de comprendre comment mettre en oeuvre l'étape 105.

Supposons que la trame T à coder est démultiplexée en deux sous-trames. La sous-trame la plus prioritaire ST₁ contient, après codage 104, 10 bits et la sous-trame la moins prioritaire ST₀ contient 5 bits. On définit un vecteur V_{deg} de même taille que la trame T' en entrée de l'étape de codage LDPC 106. La taille du vecteur V_{deg} et de la trame T' est, dans cet exemple, égale à 15. Le vecteur V_{deg} contient les indices des noeuds variables systématiques triés dans l'ordre croissant de leurs degrés. Par exemple, le vecteur V_{deg} est égal à [5 ;1 ;15;6;12;8;14;3;7;11 ;2;4;9;13;10]. L'opération de mise en correspondance 105 consiste alors à affecter les 10 bits de la sous-trame la plus prioritaire ST₁ aux 10 premiers noeuds variables systématiques identifiés dans le vecteur V_{deg}, à savoir les noeuds d'indices [5 ;1 ;15 ; 6 ; 12 ; 8 ; 14 ; 3 ; 7 ; 11]. Les 5 bits de la sous-trame la moins prioritaire ST₀ sont affectés aux noeuds variables d'indices [2 ; 4 ; 9 ; 13 ; 10].

La description faite ci-dessus de l'étape 105 peut être aisément étendue à un nombre de sous-trames supérieur à deux.

Une deuxième stratégie de mise en oeuvre de l'étape 105 consiste au contraire à associer les sous-trames de niveaux de priorité les plus élevés avec les noeuds variables systématiques de degrés les plus élevés. Selon cette deuxième stratégie, on considère que les sous-trames de niveaux de priorité les plus élevés sont déjà protégées par l'ajout d'un code correcteur algébrique (étape 104) et on souhaite privilégier, dans la seconde étape de codage 106, cette fois la sous-trame ST₀ de niveau de priorité le plus faible qui n'a pas été protégée par un code correcteur algébrique.

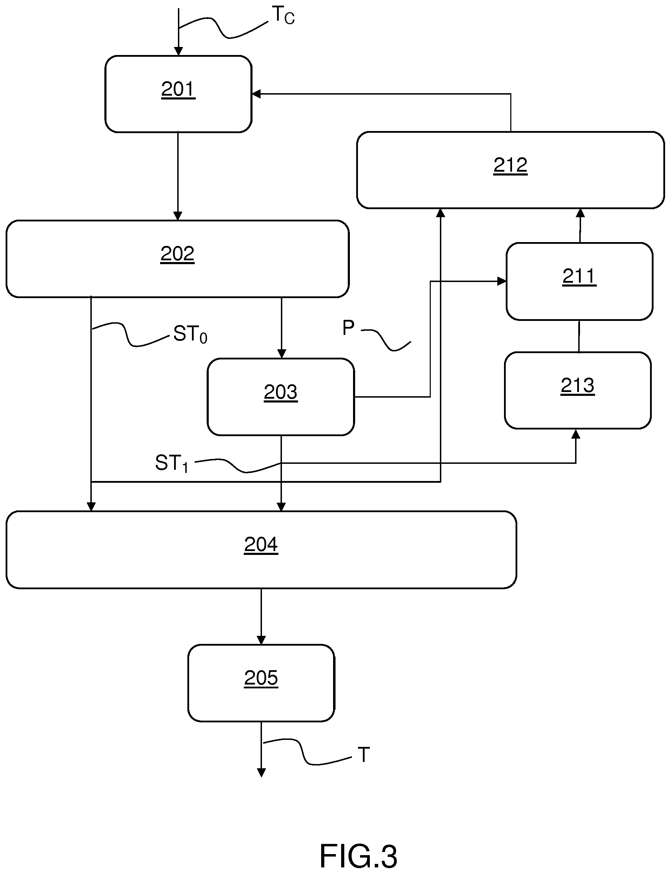

En outre, cette deuxième stratégie présente un avantage dans le cas où le décodage est réalisé en deux itérations comme cela sera explicité plus en détail par la suite dans le paragraphe associé à la figure 3.

Selon une variante de la deuxième stratégie de mise en oeuvre de l'étape 105, il est possible de construire un code correcteur LDPC en fixant le nombre de noeuds variables systématiques dont le degré est égal au degré maximum parmi l'ensemble des noeuds variables. Pour cela, on fixe tout d'abord une valeur de degré maximum dₘₐₓ, une valeur typique possible étant un degré maximum égal à dix. Ce paramètre influe sur le niveau du plancher d'erreur lors du décodage du code LDPC mais aussi sur le rapport signal à bruit obtenu pour un taux d'erreur donné par l'algorithme de décodage. Plus le degré maximum est élevé, plus le plancher d'erreur sera bas mais plus le rapport signal à bruit à partir duquel l'algorithme de décodage commence à décoder sera important.

On fixe ensuite une proportion de noeuds de degré dₘₐₓ qui est exactement égale au ratio entre le nombre de bits de la sous-trame codée de niveau de priorité le plus élevé et le nombre de bits d'un mot du code LDPC. La proportion des autres noeuds variables est définie selon des principes bien connus par l'Homme du métier et décrits notamment dans l'ouvrage de référence [1] aux chapitres 5 et 6. A l'aide de méthodes connues, on peut générer une matrice de parité du code qui est compatible des contraintes fixées ci-dessus. De cette façon, les bits de la sous-trame de niveau de priorité le plus élevé seront associés uniquement à des noeuds variables systématiques de degrés égaux au degré maximum.

Un avantage de cette variante est qu'elle permet de limiter la proportion de noeuds variables de degrés maximum ce qui permet d'améliorer le plancher d'erreur sur la courbe de taux d'erreur obtenue après décodage. En effet, selon cette variante, on limite la proportion de noeuds variables de degrés maximum à la proportion de nombre de bits de la sous-trame codée de niveau de priorité le plus élevé parmi l'ensemble des bits.

La variante décrite ci-dessus est également envisageable en fixant cette fois le nombre de noeuds variables systématiques dont le degré est égal au degré le plus faible parmi l'ensemble des noeuds variables.

L'étape de mise en correspondance 105 permet de générer une trame T' à partir des différentes sous-trames. La trame T' est ensuite codée 106 par un code correcteur systématique LDPC IRA selon une méthode de codage connue de l'Homme du métier, par exemple décrite au chapitre 6.5.2 de l'ouvrage de référence [1].

Le choix des rendements de codage du ou des codes correcteurs algébriques BCH et du code correcteur LDPC peut être fait de sorte à obtenir un rendement de codage global entre la trame d'entrée T et la trame de sortie T_{c} qui soit égal à un rendement donné.

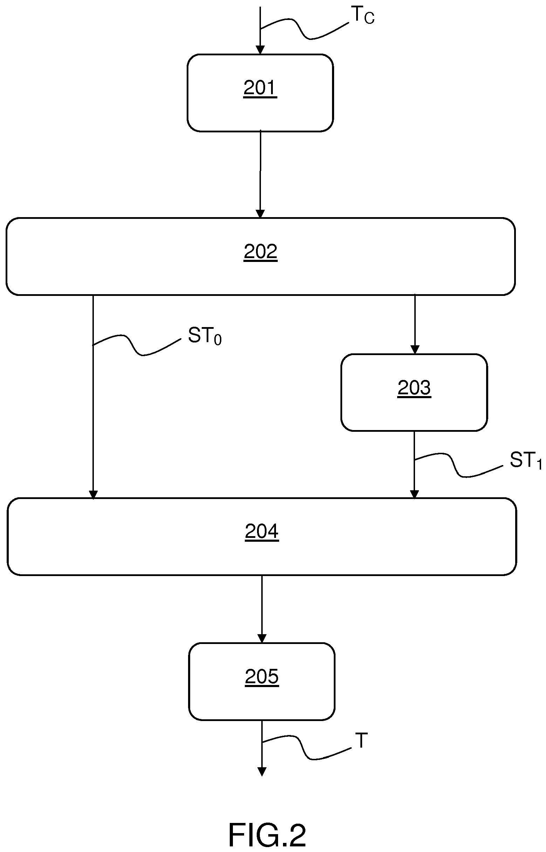

La figure 2 décrit, sur un organigramme, l'enchainement des étapes de mise en oeuvre d'un procédé de décodage, selon un premier mode de réalisation de l'invention, adapté pour décoder une trame T_{c} codée à l'aide du procédé de codage décrit à la figure 1.

La trame T_{c} est reçue en entrée du procédé de décodage selon l'invention après avoir été transmise à travers un canal de propagation non parfait, par exemple un canal de transmission par satellite ou par voie radio, qui engendre potentiellement des erreurs sur les bits de la trame T_{c} lorsqu'elle est reçue par un récepteur.

Dans une première étape 201 du procédé de décodage, la trame reçue est décodée à l'aide d'un algorithme de décodage d'un code du type LDPC. L'algorithme de décodage se base sur le graphe de Tanner généré à partir de la matrice de parité du code LDPC choisi pour mettre en oeuvre le procédé de codage. Un algorithme de décodage possible peut être l'un de ceux décrits au chapitre 5 de l'ouvrage de référence [1] ou tout autre algorithme équivalent basé sur un graphe bipartite de Tanner. Un tel algorithme n'est pas décrit en détail dans le présent document car l'Homme du métier, spécialiste des codes correcteurs, saura se référer à l'ouvrage [1] ou tout autre ouvrage de référence du domaine pour implémenter cet algorithme.

Dans une deuxième étape 202, une opération de désentrelacement est effectuée sur la trame décodée obtenue en sortie de la première étape de décodage 201. L'opération de désentrelacement consiste en l'opération inverse à celle mise en oeuvre lors de l'étape 105 du procédé de codage. Autrement dit, lors de l'étape 105 du procédé de codage, la fonction d'entrelacement mise en oeuvre pour mettre en correspondance les bits des sous-trames selon leurs niveaux de priorité avec les noeuds variables systématiques du code LDPC selon leurs degrés, est sauvegardée et transmise au récepteur en charge d'implémenter le procédé de décodage selon l'invention.

L'opération de désentrelacement exécutée par l'étape 202 produit en sortie Nₜ sous-trames de niveaux de priorité différents, qui correspondent aux Nₜ sous-trames générées pendant le procédé de codage. La figure 2 décrit un exemple de scénario pour lequel Nₜ est égal à deux, mais le lecteur saura sans difficultés étendre cet exemple à une mise en oeuvre pour une valeur de Nₜ supérieure à deux.

En reprenant l'exemple numérique décrit pour illustrer l'étape 105 du procédé de codage selon l'invention, l'étape 202 consiste à générer les sous-trames ST₁ et ST₀ de la façon suivante. La sous-trame ST₁ contient les bits qui ont les indices suivants dans la trame en sortie de l'étape de décodage 201 : [5 ;1 ;15 ; 6 ; 12 ; 8 ; 14 ; 3 ; 7 ; 11]. La sous-trame ST₀ contient les bits qui ont les indices suivants : [2 ; 4 ; 9 ; 13 ; 10].

Chaque sous-trame produite en sortie de l'étape 202 est ensuite soumise, à l'exception de la sous-trame ST₀ de niveau de priorité le plus faible, à une étape 203 de décodage à l'aide d'un algorithme de décodage d'un code correcteur algébrique de type code BCH qui consiste en l'opération inverse de l'opération de codage effectuée à l'étape 104 du procédé de codage selon l'invention. Un algorithme de décodage possible est, par exemple, l'algorithme de Berlekamp-Massey décrit au paragraphe 3.3.2 de l'ouvrage de référence [1].

Les sous-trames décodées ST₁ ainsi que la sous-trame ST₀ de niveau de priorité le plus faible sont ensuite concaténées 204 pour générer une trame unique puis une dernière étape 205 de désentrelacement est appliquée pour réaliser l'opération inverse à l'opération d'entrelacement exécutée lors de l'étape 101 du procédé de codage selon l'invention qui vise à ordonner les bits de la trame T à coder en fonction de leur niveau de priorité.

La figure 3 illustre, sur un organigramme, une variante de mise en oeuvre du procédé de décodage selon l'invention.

Selon cette variante, les étapes 201 à 205 du procédé de décodage décrit à la figure 2 sont reprises à l'identique. Le code correcteur algébrique utilisé pour coder certaines sous-trames est, dans le cas de cette variante, un code correcteur et détecteur d'erreurs qui permet de détecter si la sous-trame a été correctement décodée, c'est-à-dire si elle ne contient plus d'erreurs, ou au contraire si des erreurs subsistent. Notons P l'indicateur de décodage correct ou incorrect, obtenu à l'issue de l'étape de décodage 203. Si l'indicateur P de décodage correct est positif, une seconde itération de décodage est alors exécutée. Dans cette seconde itération, la ou les étape(s) de codage 213 par un code correcteur algébrique de la ou les sous-trame(s) de niveaux de priorité élevés sont réitérées à l'identique de l'étape de codage 104 du procédé décrit à la figure 1.

Dans une étape supplémentaire 211, l'indicateur de décodage correct P fourni par l'algorithme de décodage 203 du code BCH est utilisé pour fournir une information supplémentaire à l'algorithme de décodage 201 du code LDPC. Cette information consiste à fournir une fiabilité importante, lors de la seconde itération du décodage 201 du code LDPC, aux bits qui ont été correctement décodés par le code BCH. La fiabilité importante peut être introduite en saturant, dans le graphe de Tanner du code LDPC, à une valeur maximale les informations de vraisemblance associées aux bits qui ont été correctement décodés par l'algorithme de décodage du code BCH 203. Ainsi, cette seconde itération permet d'améliorer la capacité de correction de l'algorithme de décodage du code LDPC 201 et en particulier sur les bits de la sous-trame ST₀ non protégée par un code BCH.

Autrement dit, l'étape 211 consiste à fournir à l'algorithme de décodage du code LDPC 201, un vecteur de vraisemblances des bits produits en sortie de l'étape de codage BCH 213 dans lequel les valeurs sont saturées à des valeurs maximales. Par exemple, si la valeur maximale possible d'une vraisemblance est égale à 50, les vraisemblances fournies à l'étape 211 sont égales à +50 pour un bit égal à 1 et à -50 pour un bit égal à 0. Le terme vraisemblance est bien connu du domaine des algorithmes de décodage de codes correcteurs, il désigne une information souple associée à un bit, autrement dit une information sur la probabilité de sa valeur. Par exemple, si les valeurs de vraisemblances varient entre -50 et +50. La valeur -50 correspond à une certitude élevée que le bit est égal à 0, la valeur +50 correspond à une certitude élevée que le bit est égal à 1 et les valeurs intermédiaires correspondent à des probabilités moins élevées. La valeur 0 correspond à une probabilité égale que le bit soit à 0 ou à 1. Du fait de l'information de décodage correct, on sait que les bits en sortie de l'étape de codage BCH 213 sont corrects, on peut donc saturer leurs valeurs de vraisemblances à des valeurs maximums en valeur absolue.

Lorsque le décodeur BCH 203 ne décode pas correctement une sous-trame à la 1^{ère} itération, autrement dit lorsque l'indicateur P indique un mauvais décodage, la 2^{nde} itération de l'algorithme n'est pas mise en oeuvre.

L'étape 212 d'entrelacement et de mise en correspondance du vecteur de vraisemblances (associés aux bits produits par l'étape de codage BCH 213) avec les noeuds variables systématiques du code LDPC est similaire à l'étape 105 du procédé de codage décrit à la figure 1 à la différence prêt que l'étape 212 se limite à remplacer, dans le mot de code en entrée de l'étape de décodage LDPC 201, les valeurs des bits correspondants aux sous-trames codées par un code algébrique BCH, par les valeurs des bits obtenues en sortie de l'étape de codage BCH 213. De même, les valeurs des vraisemblances associées à ces bits sont remplacées par les valeurs saturées des vraisemblances calculées dans l'étape supplémentaire 211

La deuxième variante du procédé de décodage selon l'invention, qui inclue une seconde itération de décodage, est particulièrement avantageuse lorsque les bits des sous-trames de niveaux de priorité les plus élevés sont associés aux noeuds variables systématiques de degrés les plus élevés. En effet, lors de la seconde itération, les bits des sous-trames les plus prioritaires, qui sont protégés par un code BCH, bénéficient d'une fiabilité importante du fait de l'information de décodage correct fournie par le décodeur BCH à la première itération de décodage. Comme ces bits sont associés aux noeuds variables de degrés les plus élevés qui sont les noeuds qui présentent une plus grande probabilité d'erreur du fait de leurs nombreuses connections, la seconde itération de décodage va sensiblement améliorer le décodage de la sous-trame la moins prioritaire (celle qui n'est pas protégée par un code BCH) puisque celle-ci est associée aux noeuds variables de degrés les plus faibles.

Si à l'inverse, on associe les bits de la sous-trame la moins prioritaire aux noeuds variables de degrés les plus élevés et les bits des sous-trames protégées par le code BCH aux noeuds variables de degrés les plus faibles, l'information de décodage correct fournie par le décodeur BCH va améliorer la fiabilité sur les noeuds variables de degrés les plus faibles, ce qui est moins avantageux car, naturellement, les noeuds variables de degrés les plus faibles sont moins connectés et ont une plus faible probabilité d'erreur que les noeuds variables de degrés les plus élevés.

Selon encore une autre variante (non décrite sur les figures), l'algorithme de décodage 203 du code BCH peut être directement intégré et fusionné avec l'algorithme de décodage 201 du code LDPC.

Pour cela, on génère une matrice de parité globale associée au procédé de codage selon l'invention, à partir des matrices de parité respectives du code BCH et du code LDPC. Les premières lignes de la matrice de parité globale correspondent aux équations de parité du code BCH. L'algorithme de décodage global 201 peut alors être exécuté directement sous la forme d'un algorithme de décodage d'un code LDPC.

Lorsque le procédé de décodage fonctionne en deux itérations, à l'issue de la 1 ere itération, on vérifie les équations de parité sur la partie de la matrice de parité qui correspond au code BCH et on calcule les syndromes associés à ces équations, selon un principe connu dans le domaine des algorithmes de décodage de codes BCH. Si les syndromes sont nuls, on effectue une seconde itération de décodage de la même façon que celle décrite à la figure 3. C'est-à-dire qu'on applique les étapes 213,211,212, avant la seconde passe de décodage LDPC. Si les syndromes sont non nuls, la seconde itération n'est pas enclenchée.

En réalisant conjointement le décodage LDPC et le décodage BCH via un seul algorithme de décodage, l'étape 203 de décodage BCH spécifique est éliminée.

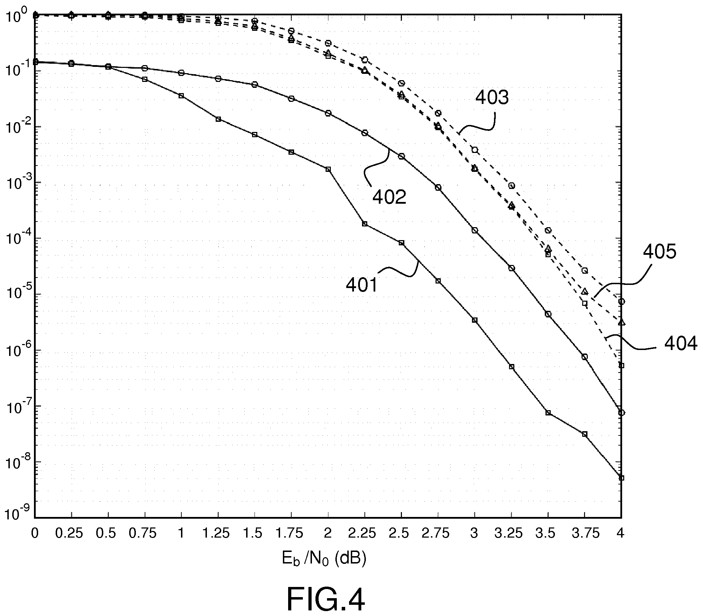

La figure 4 illustre les performances obtenues grâce à l'invention sur un diagramme représentant en ordonnée le taux d'erreurs en fonction du rapport signal à bruit Eb/N0 exprimé en décibels. Le canal de propagation est un canal simulé basé sur un modèle de bruit blanc additif Gaussien. Les résultats de mesures de taux d'erreurs sont obtenues pour des simulations réalisées sur un grand nombre de trames T codées à l'aide du procédé de codage selon l'invention, soumises à l'ajout d'erreurs représentatives de celles engendrées par un canal de propagation puis décodées à l'aide du procédé de décodage selon l'invention. Les courbes de performance de la figure 4 sont obtenues pour des trames T comprenant 300 bits, décomposées en deux sous-trames. La sous-trame ST₁ la plus prioritaire est protégée par un code correcteur BCH de paramètres (K,N)=(40,64), avec R=K/N le rendement du code BCH. Le code LDPC est défini par une matrice génératrice H à 300 lignes et 600 colonnes. Les paramètres du code LDPC sont donnés par les proportions λᵢ de noeuds variables de degrés i :{λ1=0.0004 ; λ₂=0.2546 ; λ₄=0.0899 ; λ₇=0.2097 ; λ₁₀=0.44551. Le degré maximum est égal à dix. Cet exemple numérique est donné à titre purement illustratif et non limitatif. Dans cet exemple, les bits de la sous-trame la plus prioritaire ST₁ sont mis en correspondance avec les noeuds variables systématiques de degré maximum.

La courbe 401 représente le taux d'erreurs bits mesuré après décodage sur la sous-trame la plus prioritaire ST₁.

La courbe 402 représente le taux d'erreurs bits mesuré après décodage sur la sous-trame la moins prioritaire ST₀.

La courbe 403 représente le taux d'erreurs trames mesuré uniquement sur les sous-trames les moins prioritaires ST₀.

La courbe 404 représente le taux d'erreurs trames mesuré uniquement sur les sous-trames les plus prioritaires ST₁.

La courbe 405 représente le taux d'erreurs trames mesuré uniquement sur les sous-trames les moins prioritaires ST₀ avec un décodage opéré selon la variante de réalisation décrite à la figure 3 dans laquelle une seconde itération de décodage est réalisée.

Les différentes courbes représentées à la figure 4 permettent d'évaluer l'apport de l'invention en termes de gain sur le rapport signal à bruit obtenu pour un taux d'erreurs donné. En particulier, on remarque que le taux d'erreurs (bits ou trames) sur les sous-trames les plus prioritaires est amélioré par rapport au taux d'erreurs sur les sous-trames les moins prioritaires. En outre, l'ajout d'une seconde itération de décodage permet de ramener le taux d'erreurs sur la classe de bits moins prioritaires sensiblement au même niveau que le taux d'erreurs obtenu sur la classe de bits les plus prioritaires.

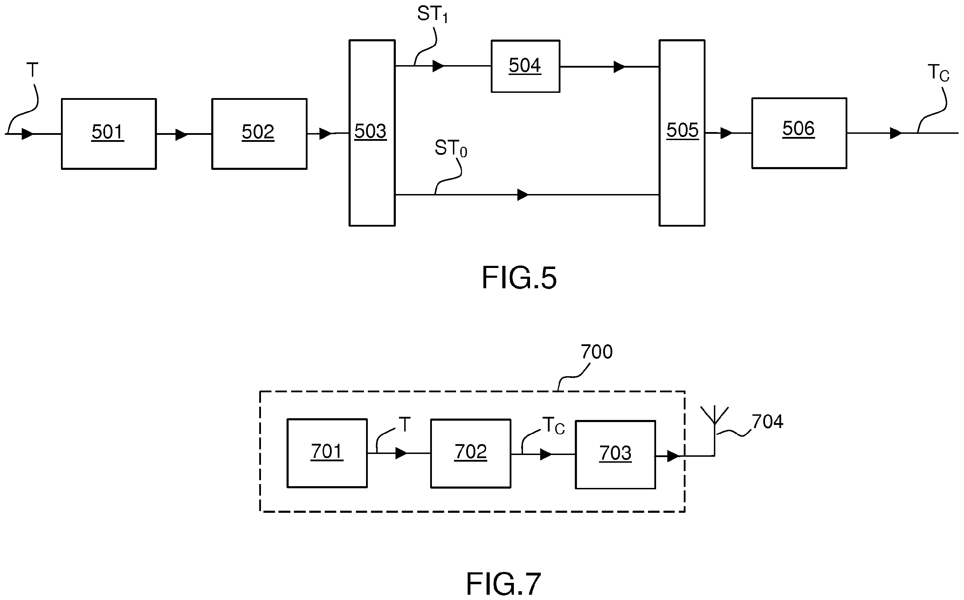

La figure 5 représente schématiquement un synoptique d'un codeur à protection différenciée selon l'invention, apte à mettre en oeuvre le procédé de codage décrit à la figure 1.

Le codeur 500 selon l'invention reçoit en entrée une trame T de bits à coder et produit en sortie une trame T_{c} de bits codés. Le codeur 500 comprend différents modules configurés pour exécuter les étapes du procédé de codage décrit à la figure 1. En particulier, le codeur 500 comprend un premier module 501 d'affectation d'un niveau de priorité aux bits de la trame T, un deuxième module 502 d'entrelacement pour regrouper les bits en groupes de niveaux de priorité équivalents ou proches, un démultiplexeur 503 pour séparer la trame T en plusieurs sous-trames ST₀, ST₁, au moins un codeur 504 algébrique de type codeur BCH, un troisième module 505 d'entrelacement et de multiplexage des sous-trames et un codeur 506 systématique de type codeur LDPC.

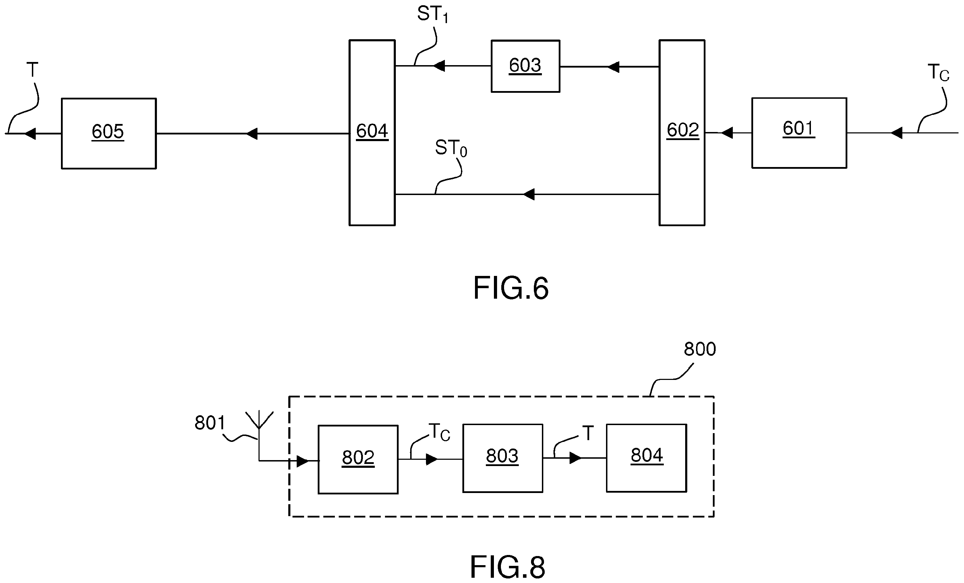

La figure 6 représente schématiquement un synoptique d'un décodeur selon l'invention adapté pour décoder des trames codées par le codeur selon l'invention décrit à la figure 5.

Le décodeur 600 selon l'invention reçoit en entrée une trame T_{c} de bits codés et produit en sortie une trame T de bits décodés. Le décodeur 600 comprend différents modules configurés pour exécuter les étapes du procédé de décodage décrit aux figures 2 et 3. En particulier, le décodeur 600 comprend un décodeur 601 pour décoder un mot de code LDPC, un module 602 de désentrelacement et de démultiplexage pour générer des sous-trames associées à des niveaux de priorité, au moins un décodeur 603 pour décoder un mot d'un code algébrique de type code BCH, un multiplexeur 604 pour concaténer plusieurs sous-trames en une trame unique et un désentrelaceur 605 pour reconstituer l'ordre initial des bits dans la trame d'origine.

Le décodeur 600 peut comprendre d'autres modules pour exécuter les étapes supplémentaires décrites dans la variante du procédé de décodage illustré à la figure 3.

Les différents modules décrits aux figures 5 et 6 sont donnés à titre d'exemples de réalisation. Sans sortir du cadre de l'invention, d'autres architectures sont envisageables, par exemple en regroupant plusieurs étapes d'un procédé au sein d'un même module ou au contraire en faisant exécuter une étape par plusieurs modules.

La figure 7 représente un synoptique d'un émetteur 700 comprenant un codeur 702 selon l'invention. L'émetteur 700 peut comporter en outre un module applicatif 701 pour générer des trames de bits T et un module radio 703 pour moduler, filtrer, mettre en forme et convertir analogiquement une trame de bits codée T_{c} avant sa transmission à une antenne 704 pour être émise sur un canal radio. L'émetteur 700 peut, par exemple, être un émetteur compatible d'un système de radio-navigation par satellite. A ce titre, l'émetteur 700 peut être embarqué dans la charge utile d'un satellite.

La figure 8 représente un synoptique d'un récepteur 800 comprenant un décodeur 803 selon l'invention. Le récepteur 800 comporte en outre une antenne 801 pour recevoir un signal, un module radio 802 pour convertir numériquement, filtrer et démoduler le signal et un module applicatif 804 qui reçoit les trames décodées. Le récepteur 800 peut, par exemple, être un récepteur compatible d'un système de radio-navigation par satellite. A ce titre, le récepteur 800 peut être un récepteur GNSS.

Les modules du codeur et du décodeur selon l'invention peuvent être implémentés à partir d'éléments matériel et/ou logiciel. A ce titre, l'invention peut notamment être mise en oeuvre en tant que programme d'ordinateur comportant des instructions pour son exécution. Le programme d'ordinateur peut être enregistré sur un support d'enregistrement lisible par un processeur. Le support peut être électronique, magnétique, optique ou électromagnétique.

En particulier, l'invention dans son ensemble ou chaque module du codeur ou du décodeur selon l'invention peut être implémenté par un dispositif comprenant un processeur et une mémoire. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »).

Le dispositif peut utiliser un ou plusieurs circuits électroniques dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Selon un mode de réalisation, le dispositif comprend au moins un support de stockage lisible par ordinateur (RAM, ROM, EEPROM, mémoire flash ou une autre technologie de mémoire, CD-ROM, DVD ou un autre support à disque optique, cassette magnétique, bande magnétique, disque de stockage magnétique ou un autre dispositif de stockage, ou un autre support de stockage non transitoire lisible par ordinateur) codé avec un programme d'ordinateur (c'est-à-dire plusieurs instructions exécutables) qui, lorsqu'il est exécuté sur un processeur ou plusieurs processeurs, effectue les fonctions des modes de réalisation de l'invention décrits précédemment.

A titre d'exemple d'architecture matérielle adaptée à mettre en oeuvre l'invention, un dispositif selon l'invention peut comporter un bus de communication auquel sont reliés une unité centrale de traitement ou microprocesseur (CPU, acronyme de « *Central Processing Unit »* en anglais), une mémoire morte (ROM, acronyme de « *Read Only Memory » en* anglais) pouvant comporter les programmes nécessaires à la mise en oeuvre de l'invention; une mémoire vive ou mémoire cache (RAM, acronyme de *« Random Access Memory » en* anglais) comportant des registres adaptés à enregistrer des variables et paramètres créés et modifiés au cours de l'exécution des programmes précités ; et une interface de communication ou E/S (I/O acronyme de « *Input*/*ouput »* en anglais) adaptée à transmettre et à recevoir des données.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en oeuvre des aspects des techniques décrites ici. Les moyens ou ressources informatiques peuvent notamment être distribués (*"Cloud computing"*), éventuellement avec selon des technologies de pair-à-pair. Le code logiciel peut être exécuté sur n'importe quel processeur approprié (par exemple, un microprocesseur) ou coeur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en oeuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

### Références

[1] «Channel codes, classical and modern », William E. Ryan, Shu Lin, Cambridge university press.

## Revendications

1. Procédé de codage à protection différenciée appliqué à une trame (T) comprenant un ensemble de bits, le codage étant effectué au moins à partir d'un premier code correcteur systématique du type code LDPC, représenté par un graphe bipartite, dit graphe de Tanner, comprenant une pluralité de premiers noeuds, appelés noeuds variables, ledit graphe comprenant en outre une pluralité de seconds noeuds, appelés noeuds de contrôle, chaque noeud variable étant connecté à au moins un noeud de contrôle par une branche, le nombre de branches reliées à un noeud variable étant appelé degré du noeud variable, dans lequel chaque noeud variable est associé à un bit d'un mot dudit premier code, les noeuds variables associés aux bits systématiques du mot du premier code étant appelés noeuds variables systématiques, ledit procédé comprenant les étapes suivantes :
- Décomposer (102,103) la trame (T) en une pluralité de sous-trames (ST₀, ST₁,...) ayant chacune un niveau de priorité différent,
- Appliquer (104) à chaque sous-trame (ST₁,...) obtenue, sauf à la sous-trame (ST₀) de niveau de priorité le plus faible, un second code correcteur algébrique de rendement prédéterminé, ledit rendement étant croissant avec la décroissance du niveau de priorité de chaque sous-trame lorsque le nombre de sous-trames (ST₀, ST₁,...) est au moins égal à trois,
- Appliquer (105) un entrelacement des bits de toutes les sous-trames (ST₀, ST₁,....) concaténées comprenant la dite sous-trame (ST₀) de priorité la plus faible et chaque sous-trame codée par le second code correcteur algébrique, de sorte à effectuer une mise en correspondance entre les noeuds variables systématiques dudit premier code correcteur systématique, rangés selon la valeur de leur degré, et les bits de chaque sous-trame (ST₀, ST₁,...), les sous-trames étant rangées selon leur niveau de priorité,
- Coder (106), à l'aide du premier code correcteur systématique, la trame composée des bits entrelacés de toutes les sous-trames concaténées.

2. Procédé de codage à protection différenciée selon la revendication 1 dans lequel les bits de chaque sous-trame sont mis en correspondance (105) avec les noeuds variables systématiques dudit premier code correcteur systématique, rangés dans l'ordre croissant de la valeur de leur degré selon un ordre décroissant des niveaux de priorité des sous-trames.

3. Procédé de codage à protection différenciée selon la revendication 1 dans lequel les bits de chaque sous-trame sont mis en correspondance (105) avec les noeuds variables systématiques dudit premier code correcteur systématique, rangés dans l'ordre croissant de la valeur de leur degré selon un ordre croissant des niveaux de priorité des sous-trames.

4. Procédé de codage à protection différenciée selon la revendication 3 dans lequel le premier code correcteur systématique est construit de sorte que la proportion de noeuds variables systématiques de degré égal au degré maximum est égale au ratio entre le nombre de bits de la sous-trame de niveau de priorité le plus élevé et le nombre de bits d'un mot dudit premier code correcteur systématique.

5. Procédé de codage à protection différenciée selon l'une des revendications précédentes dans lequel la décomposition (102) de la trame (T) en sous-trames (ST₀, ST₁,...) est effectuée en réordonnant les bits de la trame (T) selon leur niveau de priorité.

6. Procédé de codage à protection différenciée selon la revendication 5 dans lequel le niveau de priorité d'un bit est défini en fonction de la criticité de l'information associée au bit, du poids du bit ou de la fréquence de rafraichissement de l'information associée au bit.

7. Procédé de codage à protection différenciée selon la revendication 6 dans lequel les données transmises dans la trame sont des données d'un message de navigation par satellite généré par un système de radionavigation par satellite.

8. Procédé de codage à protection différenciée selon l'une des revendications précédentes dans lequel le second code correcteur algébrique est un code BCH.

9. Procédé de décodage à protection différenciée appliqué à une trame codée (T_{c}) comprenant un ensemble de bits codés à l'aide du procédé de codage à protection différenciée selon l'une des revendications 1 à 8, le procédé de décodage comprenant les étapes suivantes :
- Effectuer un premier décodage (201) de la trame codée à l'aide d'un premier algorithme de décodage d'un premier code correcteur systématique, du type code LDPC, basé sur l'exploitation d'un graphe bipartite, de sorte à obtenir une première trame décodée,
- Décomposer (202) la première trame décodée en sous-trames, chaque sous-trame contenant les bits correspondant aux noeuds variables systématiques rangés selon la valeur de leur degré, les sous-trames étant rangées selon leur niveau de priorité,
- Effectuer un second décodage (203) de chaque sous-trame obtenue, sauf de la trame de niveau de priorité le plus faible, à l'aide d'un second algorithme de décodage d'un second code correcteur algébrique de rendement prédéterminé, ledit rendement étant croissant avec la décroissance du niveau de priorité de chaque sous-trame lorsque le nombre de sous-trames est au moins égal à trois.

10. Procédé de décodage à protection différenciée selon la revendication 9 comprenant en outre une étape de concaténation (204) des sous-trames en une seconde trame décodée.

11. Procédé de décodage à protection différenciée selon l'une des revendications 9 ou 10 dans lequel le second code correcteur est un code correcteur et détecteur d'erreurs, ledit procédé de décodage comprenant en outre les étapes suivantes :
- Lors du second décodage (203) de chaque sous-trame, détecter (P) si la sous-trame est correctement décodée ou non,
- Si la sous-trame est correctement décodée,
i. Coder (213), avec ledit second code correcteur algébrique, chaque sous-trame décodée pour obtenir une sous-trame codée,
ii. Appliquer une seconde itération du premier décodage (201) en spécifiant à l'algorithme de décodage dudit premier code correcteur systématique, une vraisemblance maximale pour les bits de chaque sous-trame codée.

12. Procédé de décodage à protection différenciée selon l'une des revendications 9 à 11 dans lequel le second code correcteur algébrique est un code BCH.

13. Procédé de décodage à protection différenciée selon l'une des revendications 9 à 12 dans lequel le décodage (201) du premier code correcteur systématique et le décodage (203) du second code correcteur algébrique, sont réalisés conjointement.

14. Dispositif de codage à protection différenciée, le codage étant destiné à être appliqué à une trame (T) comprenant un ensemble de bits, le dispositif comprenant au moins un premier codeur correcteur d'erreurs pour coder un code systématique du type code LDPC, représenté par un graphe bipartite, dit graphe de Tanner, comprenant une pluralité de premiers noeuds, appelés noeuds variables, ledit graphe comprenant en outre une pluralité de seconds noeuds, appelés noeuds de contrôle, chaque noeud variable étant connecté à au moins un noeud de contrôle par une branche, le nombre de branches reliées à un noeud variable étant appelé degré du noeud variable, dans lequel chaque noeud variable est associé à un bit d'un mot dudit premier code, les noeuds variables associés aux bits systématiques du mot du premier code étant appelés noeuds variables systématiques, le dispositif comprenant en outre,
- des moyens pour décomposer la trame (T) en une pluralité de sous-trames (ST₀, ST₁,...) ayant chacune un niveau de priorité différent,
- des moyens pour appliquer à chaque sous-trame obtenue, sauf à la sous-trame (ST₀) de niveau de priorité le plus faible, un second code correcteur algébrique de rendement prédéterminé, ledit rendement étant croissant avec la décroissance du niveau de priorité de chaque sous-trame lorsque le nombre de sous-trames est au moins égal à trois,
- des moyens pour appliquer un entrelacement des bits de toutes les sous-trames concaténées comprenant la dite sous-trame de priorité la plus faible et chaque sous-trame codée par le second code correcteur algébrique, de sorte à effectuer une mise en correspondance entre les noeuds variables systématiques dudit premier code correcteur systématique, rangés selon la valeur de leur degré, et les bits de chaque sous-trame, les sous-trames étant rangées selon leur niveau de priorité,
- des moyens pour coder, à l'aide du premier code correcteur systématique, la trame composée des bits entrelacés de toutes les sous-trames concaténées.

15. Dispositif de décodage à protection différenciée, le décodage étant destiné à être appliquée à une trame codée (T_{c}) comprenant un ensemble de bits codés à l'aide du procédé de codage à protection différenciée selon l'une des revendications 1 à 8, le dispositif de décodage comprenant:
- des moyens pour effectuer un premier décodage de la trame codée à l'aide d'un premier algorithme de décodage d'un premier code correcteur systématique, du type code LDPC, basé sur l'exploitation d'un graphe bipartite, de sorte à obtenir une première trame décodée,
- des moyens pour décomposer la première trame décodée en sous-trames, chaque sous-trame contenant les bits correspondant aux noeuds variables systématiques rangés selon la valeur de leur degré, les sous-trames étant rangées selon leur niveau de priorité,
- des moyens pour effectuer un second décodage de chaque sous-trame obtenue, sauf de la trame de niveau de priorité le plus faible, à l'aide d'un second algorithme de décodage d'un second code correcteur algébrique de rendement prédéterminé, ledit rendement étant croissant avec la décroissance du niveau de priorité de chaque sous-trame lorsque le nombre de sous-trames est au moins égal à trois.

16. Emetteur de signaux de radio-navigation par satellite comprenant un dispositif de codage selon la revendication 14 pour coder de façon différenciée des messages de radio-navigation par satellite.

17. Récepteur de signaux de radio-navigation par satellite comprenant un dispositif de décodage selon la revendication 15 pour décoder de façon différenciée des messages de radio-navigation par satellite.

## Patentansprüche

1. Verfahren zum Codieren mit differenziertem Schutz, angewendet auf einen Frame (T), der einen Satz von Bits umfasst, wobei die Codierung wenigstens auf der Basis eines ersten systematischen Korrekturcode des LDPC-Codetyps erfolgt, repräsentiert durch eine zweiteilige Grafik, Tanner-Grafik genannt, umfassend mehrere erste Knoten, variable Knoten genannt, wobei die Grafik ferner mehrere zweite Knoten umfasst, Prüfknoten genannt, wobei jeder variable Knoten mit wenigstens einem Prüfknoten durch einen Zweig verbunden ist, wobei die Anzahl von mit einem variablen Knoten verbundenen Zweigen Grad des variablen Knotens genannt wird, wobei jeder variable Knoten mit einem Bit eines Wortes des ersten Code assoziiert ist, wobei die mit den systematischen Bits des Wortes des ersten Code assoziierten variablen Knoten systematische variable Knoten genannt werden, wobei das Verfahren die folgenden Schritte beinhaltet:
- Zerlegen (102, 103) des Frame (T) in eine Mehrzahl von Subframes (ST₀, ST₁, ...) jeweils mit einer anderen Prioritätsstufe,
- Anwenden (104) auf jeden erhaltenen Subframe (ST₁,...), mit Ausnahme des Subframe (ST₀) mit der niedrigsten Prioritätsstufe, eines zweiten algebraischen Korrekturcode mit vorbestimmter Effizienz, wobei die Effizienz mit abnehmender Prioritätsstufe jedes Subframe zunimmt, wenn die Anzahl von Subframes (ST₀, ST₁, ...) wenigstens gleich drei ist,
- Anwenden (105) einer Verflechtung der Bits aller verketteten Subframes (ST_{0,} ST₁,...), die den Subframe (ST₀) mit der niedrigsten Priorität und jeden Subframe umfassen, der durch den zweiten algebraischen Korrekturcode codiert wird, um zwischen den systematischen variablen Knoten des ersten systematischen Korrekturcode, geordnet nach dem Wert ihres Grades, und den Bits jedes Subframe (ST₀, ST₁, ...) zu korrelieren, wobei die Subframes nach ihrer Prioritätsstufe geordnet sind,
- Codieren (106), mit Hilfe des ersten systematischen Korrekturcode, des Frame bestehend aus den verflochtenen Bits aller verketteten Subframes.

2. Verfahren zum Codieren mit differenziertem Schutz nach Anspruch 1, bei dem die Bits jedes Subframe mit den systematischen variablen Knoten des ersten systematischen Korrekturcode korreliert werden (105), geordnet nach zunehmendem Wert ihres Grades gemäß einer abnehmenden Ordnung der Prioritätsstufen der Subframes.

3. Verfahren zum Codieren mit differenziertem Schutz nach Anspruch 1, bei dem die Bits jedes Subframe mit den systematischen variablen Knoten des ersten systematischen Korrekturcode korreliert werden (105), geordnet nach zunehmendem Wert ihres Grades gemäß einer zunehmenden Ordnung der Prioritätsstufen der Subframes.

4. Verfahren zum Codieren mit differenziertem Schutz nach Anspruch 3, bei dem der erste systematische Korrekturcode so aufgebaut ist, dass der Anteil von systematischen variablen Knoten eines Grades gleich dem maximalen Grad gleich dem Verhältnis zwischen der Anzahl von Bits des Subframe mit der höchsten Prioritätsstufe und der Anzahl von Bits eines Wortes des ersten systematischen Korrekturcode ist.

5. Verfahren zum Codieren mit differenziertem Schutz nach einem der vorherigen Ansprüche, bei dem die Zerlegung (102) des Frame (T) in Subframes (ST₀, ST₁, ...) durch Umordnen der Bits des Frame (T) nach ihrer Prioritätsstufe erfolgt.

6. Verfahren zum Codieren mit differenziertem Schutz nach Anspruch 5, bei dem die Prioritätsstufe von einem Bit in Abhängigkeit von der Kritikalität der mit dem Bit assoziierten Information, der Gewichtung des Bits oder der Auffrischungshäufigkeit der mit dem Bit assoziierten Information definiert wird.

7. Verfahren zum Codieren mit differenziertem Schutz nach Anspruch 6, bei dem die in dem Frame übertragenen Daten Daten einer Satellitennavigationsnachricht sind, die von einem Satellitenfunknavigationssystem erzeugt wurde.

8. Verfahren zum Codieren mit differenziertem Schutz nach einem der vorherigen Ansprüche, bei dem der zweite algebraische Korrekturcode ein BCH-Code ist.

9. Verfahren zum Decodieren mit differenziertem Schutz, angewendet auf einen codierten Frame (T_{c}), umfassend einen Satz von Bits, die mit dem Verfahren zum Codieren mit differenziertem Schutz nach einem der Ansprüche 1 bis 8 codiert wurden, wobei das Decodierverfahren die folgenden Schritte beinhaltet:
- Bewirken einer ersten Decodierung (201) des Frame, der mit Hilfe eines ersten Decodieralgorithmus eines ersten systematischen Korrekturcode codiert wurde, vom LDPC-Codetyp, auf der Basis der Nutzung einer zweiteiligen Grafik, um einen ersten decodierten Frame zu erhalten,
- Zerlegen (202) des ersten decodierten Frame in Subframes, wobei jeder Subframe die Bits enthält, die den systematischen variablen Knoten entsprechen, die nach dem Wert ihres Grades geordnet sind, wobei die Subframes nach ihrer Prioritätsstufe geordnet sind,
- Bewirken einer zweiten Decodierung (203) jedes erhaltenen Subframe, mit Ausnahme des Frame mit der niedrigsten Prioritätsstufe, mit Hilfe eines zweiten Decodieralgorithmus eines zweiten algebraischen Korrekturcode mit vorbestimmter Effizienz, wobei die Effizienz mit abnehmender Prioritätsstufe jedes Subframe zunimmt, wenn die Anzahl von Subframes wenigstens drei ist.

10. Decodierverfahren mit differenziertem Schutz nach Anspruch 9, das ferner einen Schritt des Verkettens (204) der Subframes in einen zweiten decodierten Frame beinhaltet.

11. Decodierverfahren mit differenziertem Schutz nach Anspruch 9 oder 10, bei dem der zweite Korrekturcode ein Fehlerkorrektur- und -erkennungscode ist, wobei das Decodierverfahren ferner die folgenden Schritte beinhaltet:
- Erkennen (P), beim zweiten Decodieren (203) jedes Subframe, ob der Subframe korrekt decodiert ist oder nicht,
- wenn der Subframe korrekt decodiert ist:
i. Codieren (213), mit dem zweiten algebraischen Korrekturcode, jedes decodierten Subframe, um einen codierten Subframe zu erhalten,
ii. Anwenden einer zweiten Iteration der ersten Decodierung (201) durch Vorgeben, dem Decodieralgorithmus des ersten systematischen Korrekturcode, einer maximalen Wahrscheinlichkeit für die Bits jedes codierten Subframe.

12. Decodierverfahren mit differenziertem Schutz nach einem der Ansprüche 9 bis 11, wobei der zweite algebraische Korrekturcode ein BCH-Code ist.

13. Decodierverfahren mit differenziertem Schutz nach einem der Ansprüche 9 bis 12, wobei die Decodierung (201) des ersten systematischen Korrekturcode und die Decodierung (203) des zweiten algebraischen Korrekturcode gemeinsam realisiert werden.

14. Vorrichtung zum Codieren mit differenziertem Schutz, wobei die Codierung zur Anwendung auf einen Frame (T) bestimmt ist, der einen Satz von Bits umfasst, wobei die Vorrichtung Folgendes umfasst: wenigstens einen ersten Fehlerkorrekturcodierer zum Codieren eines systematischen Code des LDPC-Code-Typs, repräsentiert durch eine zweiteilige Grafik, Tanner-Grafik genannt, umfassend mehrere erste Knoten, variable Knoten genannt, wobei die Grafik ferner mehrere zweite Knoten umfasst, Prüfknoten genannt, wobei jeder variable Knoten mit wenigstens einem Prüfknoten durch einen Zweig verbunden ist, wobei die Anzahl von mit einem variablen Knoten verbundenen Zweigen Grad des variablen Knotens genannt wird, wobei jeder variable Knoten mit einem Bit eines Wortes des ersten Code assoziiert ist, wobei die mit den systematischen Bits des Wortes des ersten Code assoziierten variablen Knoten systematische variable Knoten genannt werden, wobei die Vorrichtung ferner Folgendes umfasst:
- Mittel zum Zerlegen des Frame (T) in mehrere Subframes (ST₀, ST₁, ...) jeweils mit einer anderen Prioritätsstufe,
- Mittel zum Anwenden, auf jeden erhaltenen Subframe, mit Ausnahme des Subframe (ST₀) mit der niedrigsten Prioritätsstufe, eines zweiten algebraischen Korrekturcode mit vorbestimmter Effizienz, wobei die Effizienz mit abnehmender Prioritätsstufe jedes Subframe zunimmt, wenn die Anzahl von Subframes wenigstens gleich drei ist,
- Mittel zum Anwenden einer Verflechtung von Bits aller verketteten Subframes, die den Subframe mit der niedrigsten Priorität umfassen, und jedes Subframe, der mit dem zweiten algebraischen Korrekturcode codiert ist, um zwischen den systematischen variablen Knoten des ersten systematischen Korrekturcode, geordnet nach dem Wert ihres Grades, und den Bits jedes Subframe zu korrelieren, wobei die Subframe nach ihrer Prioritätsstufe geordnet sind,
- Mittel zum Codieren, mit Hilfe des ersten systematischen Korrekturcode, des Frame bestehend aus verflochtenen Bits aller verketteten Subframes.

15. Vorrichtung zum Decodieren mit differenziertem Schutz, wobei die Decodierung zur Anwendung auf einen codierten Frame (T_{c}) bestimmt ist, der einen Satz von Bits umfasst, die mit dem Codierverfahren mit differenziertem Schutz nach einem der Ansprüche 1 bis 8 codiert sind, wobei die Decodiervorrichtung Folgendes umfasst:
- Mittel zum Bewirken einer ersten Decodierung des Frame, der mit Hilfe eines ersten Decodieralgorithmus eines ersten systematischen Korrekturcode codiert ist, vom LDPC-Codetyp, auf der Basis der Nutzung einer zweiteiligen Grafik, um einen ersten decodierten Frame zu erhalten,
- Mittel zum Zerlegen des ersten decodierten Frame in Subframes, wobei jeder Subframe die Bits enthält, die den systematischen variablen Knoten entsprechen, die nach dem Wert ihres Grades geordnet sind, wobei die Subframes nach ihrer Prioritätsstufe geordnet sind,
- Mittel zum Bewirken einer zweiten Decodierung jedes erhaltenen Subframe, mit Ausnahme des Frame mit der niedrigsten Prioritätsstufe, mit Hilfe eines zweiten Decodieralgorithmus eines zweiten algebraischen Korrekturcode mit vorbestimmter Effizienz, wobei der Effizienz mit abnehmender Prioritätsstufe jedes Subframe zunimmt, wenn die Anzahl von Subframes wenigstens gleich drei ist.

16. Sender für Satellitenfunknavigationssignale, umfassend eine Codiervorrichtung nach Anspruch 14 zum Codieren von Satellitenfunknavigationsnachrichten auf differenzierte Weise.

17. Empfänger von Satellitenfunknavigationssignalen, umfassend eine Decodiervorrichtung nach Anspruch 15 zum Decodieren von Satellitenfunknavigationsnachrichten auf differenzierte Weise.

## Claims

1. A coding method with differentiated protection applied to a frame (T) comprising a set of bits, the coding being performed at least from a first systematic correcting code of the LDPC code type, represented by a bipartite graph, called a Tanner graph, comprising a plurality of first nodes, called variable nodes, said graph further comprising a plurality of second nodes, called check nodes, each variable node being connected to at least one check node by a branch, the number of branches connected to a variable node being called degree of the variable node, in which each variable node is associated with a bit of a word of said first code, the variable nodes associated with the systematic bits of the word of the first code being called systematic variable nodes, said method comprising the following steps:
- decomposing (102, 103) the frame (T) into a plurality of subframes (ST₀, ST₁, ...) each having a different priority level,
- applying (104) to each subframe (ST₁,...) obtained, except for the subframe (ST₀) of lowest priority level, a second algebraic correcting code of predetermined efficiency, said efficiency increasing as the priority level of each subframe decreases when the number of subframes (ST₀, ST₁,...) is at least equal to three,
- applying (105) an interleaving of the bits of all the concatenated subframes (ST₀, ST₁,...) comprising said subframe (ST₀) of lowest priority and each subframe coded by the second algebraic correcting code, so as to perform a correlation between the systematic variable nodes of said first systematic correcting code, arranged according to the value of their degree, and the bits of each subframe (ST₀, ST₁,...), the subframes being arranged according to their priority level,
- coding (106), using the first systematic correcting code, the frame composed of the interleaved bits of all the concatenated subframes.

2. The coding method with differentiated protection according to claim 1, in which the bits of each subframe are correlated (105) with the systematic variable nodes of said first systematic correcting code, arranged in ascending order of the value of their degree according to a descending order of the priority levels of the subframes.

3. The coding method with differentiated protection according to claim 1, in which the bits of each subframe are correlated (105) with the systematic variable nodes of said first systematic correcting code, arranged in ascending order of the value of their degree according to an ascending order of the priority levels of the subframes.

4. The coding method with differentiated protection according to claim 3, in which the first systematic correcting code is constructed such that the proportion of systematic variable nodes of a degree equal to the maximum degree is equal to the ratio between the number of bits of the subframe of highest priority level and the number of bits of a word of said first systematic correcting code.

5. The coding method with differentiated protection according to any of the preceding claims, in which the decomposition (102) of the frame (T) into subframes (ST₀, ST₁,...) is performed by re-ordering the bits of the frame (T) according to their priority level.

6. The coding method with differentiated protection according to claim 5, in which the priority level of a bit is defined as a function of the criticality of the information associated with the bit, of the weight of the bit or of the refresh frequency of the information associated with the bit.

7. The coding method with differentiated protection according to claim 6, in which the data transmitted in the frame are data of a satellite navigation message generated by a satellite radio-navigation system.

8. The coding method with differentiated protection according to any of the preceding claims, in which the second algebraic correcting code is a BCH code.

9. A decoding method with differentiated protection applied to a coded frame (T_{c}) comprising a set of bits coded using the coding method with differentiated protection according to any of claims 1 to 8, the decoding method comprising the following steps:
- performing a first decoding (201) of the coded frame using a first decoding algorithm of a first systematic correcting code of the LDPC code type, based on the use of a bipartite graph, so as to obtain a first decoded frame,
- decomposing (202) the first decoded frame into subframes, each subframe containing the bits corresponding to the systematic variable nodes arranged according to the value of their degree, the subframes being arranged according to their priority level,
- performing a second decoding (203) of each subframe obtained, except the frame of lowest priority level, using a second decoding algorithm of a second algebraic correcting code of predetermined efficiency, said efficiency increasing as the priority level of each subframe decreases when the number of subframes is at least equal to three.

10. The decoding method with differentiated protection according to claim 9, further comprising a step of concatenation (204) of the subframes in a second decoded frame.

11. The decoding method with differentiated protection according to either of claims 9 or 10, in which the second correcting code is an error correcting and detecting code, said decoding method further comprising the following steps:
- during the second decoding (203) of each subframe, detecting (P) whether the subframe is correctly decoded or not,
- if the subframe is correctly decoded,
i. coding (213) with said second algebraic correcting code, each decoded subframe to obtain a coded subframe,
ii. applying a second iteration of the first decoding (201) by specifying, to the decoding algorithm of said first systematic correcting code, a maximum likelihood for said bits of each coded subframe.

12. The decoding method with differentiated protection according to any of claims 9 to 11, in which the second algebraic correcting code is a BCH code.

13. The decoding method with differentiated protection according to any of claims 9 to 12, in which the decoding (201) of said first systematic correcting code and the decoding (203) of the second algebraic correcting code are performed jointly.

14. A coding device with differentiated protection, the coding being intended to be applied to a frame (T) comprising a set of bits, the device comprising at least a first error correcting coder for coding a systematic code of the LDPC code type, represented by a bipartite graph, called a Tanner graph, comprising a plurality of first nodes, called variable nodes, said graph further comprising a plurality of second nodes, called check nodes, each variable node being connected to at least one check node by a branch, the number of branches connected to a variable node being called degree of the variable node, in which each variable node is associated with a bit of a word of said first code, the variable nodes associated with the systematic bits of the word of the first code being called systematic variable nodes, the device further comprising
- means for decomposing the frame (T) into a plurality of subframes (ST₀, ST₁, ...) each having a different priority level,
- means for applying to each subframe obtained, except for the subframe (ST₀) of lowest priority level, a second algebraic correcting code of predetermined efficiency, said efficiency increasing as the priority level of each subframe decreases when the number of subframes is at least equal to three,
- means for applying an interleaving of the bits of all the concatenated subframes comprising said subframe of lowest priority and each subframe coded by the second algebraic correcting code so as to perform a correlation between the systematic variable nodes of said first systematic correcting code, arranged according to the value of their degree, and the bits of each subframe, the subframes being arranged according to their priority level,
- means for coding, using the first systematic correcting code, the frame composed of the interleaved bits of all the concatenated subframes.

15. A decoding device with differentiated protection, the decoding being intended to be applied to a coded frame (T_{c}) comprising a set of bits coded using the coding process with differentiated protection according to any of claims 1 to 8, the decoding device comprising:
- means for performing a first decoding of the coded frame using a first decoding algorithm of a first systematic correcting code of the LDPC code type, based on the use of a bipartite graph, so as to obtain a first decoded frame,
- means for decomposing the first decoded frame into subframes, each subframe containing the bits corresponding to the systematic variable nodes arranged according to the value of their degree, the subframes being arranged according to their priority level,
- means for performing a second decoding of each subframe obtained, except the frame of lowest priority level, using a second decoding algorithm of a second algebraic correcting code of predetermined efficiency, said efficiency increasing as the priority level of each subframe decreases when the number of subframes is at least equal to three.

16. A satellite radio-navigation signal transmitter comprising a coding device according to claim 14 for coding, in a differentiated manner, satellite radio-navigation messages.

17. A satellite radio-navigation signal receiver comprising a decoding device according to claim 15 for decoding, in a differentiated manner, satellite radio-navigation messages.
